# EUROPÄISCHE PATENTSCHRIFT

(11) **EP 2 130 418 B1**
(45) Veröffentlichungstag und Bekanntmachung des Hinweises auf die Patenterteilung: **06.06.2012**
(21) Anmeldenummer: 08708621.1
(22) Anmeldetag: 04.02.2008
(51) Int. Cl.: H05K 3/30

(54) **VERFAHREN ZUM EINSETZEN EINES PIN IN EINE AUFNAHMEÖFFNUNG EINER LEITERPLATTE**
METHOD FOR INSERTING A PIN INTO A RECEIVING OPENING IN A CIRCUIT BOARD
PROCÉDÉ D'INTRODUCTION D'UNE BROCHE DANS UNE OUVERTURE DE RÉCEPTION D'UNE CARTE DE CIRCUITS IMPRIMÉS

(30) Priorität: 26.03.2007 DE 102007014356
(43) Veröffentlichungstag der Anmeldung: 09.12.2009
(73) Patentinhaber: Robert Bosch GmbH, 70442 Stuttgart (DE)
(72) Erfinder: GUECKEL, Richard, 76829 Landau/Pfalz (DE)
(86) Internationale Anmeldenummer: PCT/EP2008/051317
(87) Internationale Veröffentlichungsnummer: WO 2008/116687

(56) Entgegenhaltungen:
- EP-A1- 0 703 639
- EP-A1- 1 898 496
- DE-A1- 10 219 427
- US-A1- 2002 037 672
- US-A1- 2006 264 076
- US-A1- 2007 010 139

## Beschreibung

Die Erfindung betrifft ein Verfahren zum Einsetzen eines Pin in eine Aufnahmeöffnung einer Leiterplatte gemäß dem Oberbegriff des Anspruchs 1.

Dort, wo in der Kraftfahrzeugtechnik sowie auf anderen Gebieten ein sicheres und zuverlässiges Funktionieren von Steuerungen besonders wichtig ist, wie zum Beispiel im Fall von elektronischen Steuerungen von Airbags oder anderen Insassenrückhaltevorrichtungen, im Fall von Steuerungen von automatischen Bremssystemen (ABS) oder Einrichtungen zur Fahrdynamikregelung (ESL) oder im Fall von Motor- und Getriebesteuerungen, wird zur Herstellung von hochwertigen elektrischen Kontakten zwischen einer Leiterplatte und einem oder mehreren, nachträglich auf der Leiterplatte montierten elektronischen Bauelementen zunehmend die sogenannte Einpresstechnik eingesetzt, ein Kaltkontaktierungsverfahren, bei dem ein oder mehrere überstehende Einpresspins der elektronischen Bauelemente mit Presspassung in komplementäre Aufnahmeöffnungen in der Leiterplatte eingesetzt werden. Jedoch wird die Einpresstechnik auch auf anderen Gebieten zur nachträglichen Montage von elektronischen Bauelementen auf Leiterplatten eingesetzt, zum Beispiel in Steuerungen von Fensterhebermodulen oder Heckscheibenreinigungsanlagen von Kraftfahrzeugen.

Die im Einsatz befindlichen Einpresspins besitzen eine als Feder ausgebildete Einpresszone, die im Zuge des Einpressens der Einpresspins in die Aufnahmeöffnungen der Leiterplatte quer zur Einpressrichtung zusammengedrückt wird, während die Aufnahmeöffnungen, in der Regel Standard-Leiterplattenbohrungen mit speziellem Durchmesser, aufgeweitet werden, wobei eine gewünschte Haltekraft der Einpresspins in den Aufnahmeöffnungen durch die elastische und plastische Verformung der beiden Fügepartner gewährleistet wird.

Mit dieser Technik kann in vielen Fällen ein zusätzlicher, die Leiterplatte stark belastender Lötprozess, das sogenannte Selektivlöten, vermieden werden. Außerdem zeichnen sich die durch die Einpresstechnik hergestellten elektrischen Verbindungen durch eine einwandfreie Kontaktierung und eine sehr hohe Zuverlässigkeit aus und weisen wegen der gasdichten und daher korrosionsbeständigen Verbindung zwischen den Einpresspins und der Leiterplatte einen über die projizierte Lebensdauer zuverlässig niedrigen Übertragungswiderstand auf. Darüber hinaus sind Einpressverbindungen elastisch, so dass die bei Lötverbindungen nicht selten auftretenden Unterbrechungen oder Kontaktausfälle infolge von mechanischen und thermischen Belastungen im Betrieb vermieden werden können.

Durch die zum Einpressen konventioneller Einpresspins erforderlichen hohen Einpresskräfte von etwa 70 bis 180 N/Pin werden jedoch die an die Aufnahmeöffnungen angrenzenden Bereiche der Leiterplatte in Richtung der Einpresskräfte auch starken Scherkräften ausgesetzt. Diese Kräfte zwingen zum einen die Schaltungsentwickler, an den Oberflächen der Leiterplatte um die Einmündungen der Aufnahmeöffnungen herum größere Tabuzonen vorzusehen, um ein Auftreten von Rissen in aufgelöteten Bauelementen infolge von oberflächlichen Zugspannungen in der Leiterplatte bzw. einer oberflächlichen gedruckten Schaltung oder Leiterbahn zu vermeiden. Jedoch kann dadurch ein Teil der Leiterplattenoberfläche nicht als Schaltungsfläche genutzt werden. Zum anderen kommt es beim Einpressen eines Einpresspin infolge einer starken lokalen mechanischen Belastung der Leiterplatte um die Aufnahmeöffnung herum zum Auftreten des sogenannten Jeteffekts, einer durch Scherkräfte bewirkten Verformung der Leiterplatte angrenzend an die Aufnahmeöffnung. Dieser Jeteffekt birgt bei mehrschichtigen Leiterplatten aufgrund extremer Dehnbeanspruchungen die Gefahr eines Abrisses von leitenden metallischen Innenlagen. Außerdem besteht die Gefahr, dass eine zum prozesssicheren Einpressen notwendige weiche metallische Gleitschicht auf der Oberfläche der Einpresspins beim Einpressen derselben von den Mündungsrändern der Aufnahmeöffnungen teilweise von den Pins abgeschabt wird, wobei Späne oder Flitter gebildet werden, die unter ungünstigen Umständen an anderen Stellen der Leiterplatte zu Kurzschlüssen und damit zu einem Funktionsausfall führen können.

Die DE 102 19 427 A1 offenbart einen Kontaktstift oder Pin mit einem hohl ausgebildeten Ende und einem Außenwulst, der kräftefrei in eine Öffnung einer Leiterplatte eingeführt und durch Erhitzen sowie durch Ausübung von Druck aufgeweitet werden kann, um eine Klemmverbindung zwischen dem Kontaktstift und der Leiterplatte herzustellen.

Die US 2002/0037672 A1 offenbart einen Pin, der in eine Aufnahmeöffnung einer Leiterplatte eingeführt wird. Der Pin umfasst zwei nebeneinander her verlaufende Schenkelteile, die an ihrem in Einführrichtung vorderen Endteil einstückig miteinander verbunden sind. Der Pin wird beim Einführen in die Aufnahmeöffnung gegen deren Umfangswand angepresst und elastisch verformt.

Die EP 0 703 639 A1 offenbart eine V-förmig gebogene Anschlussklemme mit zwei Schenkelteilen, die zur Steckkontaktierung in eine Öffnung einer Leiterplatte eingeführt wird. Auch hier wird während des Einführens zuerst einer der Schenkelteile und dann beide Schenkelteile gegen die Umfangswand der Aufnahmeöffnung angepresst und elastisch verformt.

In den beiden zuletzt genannten Fällen kann es infolge der Anpressung der Schenkelteile gegen die Umfangswand der Aufnahmeöffnung beim Einführen des Pin zu dem zuvor beschriebenen Jeteffekt kommen.

Aus der EP 1 898 496 A1 ist ein Pin bekannt, der in einem Befestigungsabschnitt zwei im Wesentlichen parallel verlaufende, unterschiedlich lange Schenkelteile aufweist. Der Befestigungsabschnitt wird kräftefrei in eine Öffnung eingeführt. Eine Verformung der Schenkelteile und damit eine Verankerung des Pins erfolgt, indem der längere Schenkel unter Druckbelastung umgebogen wird und durch seinen Endabschnitt den kürzeren Schenkel von sich weg biegt. Durch die so erfolgende Spreizung wird der Pin verankert.

Ausgehend hiervon liegt der Erfindung die Aufgabe zugrunde, einen Einpresspin und ein Verfahren der eingangs genannten Art dahingehend zu verbessern, dass die zuvor genannten Nachteile vermieden werden können.

Diese Aufgabe wird erfindungsgemäß durch die Merkmale im Anspruch 1 gelöst. Danach wird der Pin von einer Seite der Leiterplatte her in die Aufnahmeöffnung eingeführt und ein Kontaktteil des Pin mit Presssitz in der Aufnahmeöffnung verankert, wobei der Kontaktteil berührungslos oder mit Gleitpassung in die Aufnahmeöffnung eingeführt und anschließend innerhalb der Aufnahmeöffnung verformt wird, um ihn mit Presssitz in der Aufnahmeöffnung zu verankern, wobei der Pin bis zum Anschlagen gegen ein Widerlager auf der entgegengesetzten Seite der Leiterplatte in die Aufnahmeöffnung eingeführt wird, und wobei der Kontaktteil verformt wird, indem mindestens ein Teil des Kontaktteils zwischen einem Setzwerkzeug und dem Widerlager zusammengedrückt und dabei verbogen wird, indem das Setzwerkzeug gegen eine von der Leiterplatte abgewandte Fläche an einem über die Leiterplatte überstehenden Teil des Kontaktteils angepresst wird.

Durch die erfindungsgemäßen Merkmale werden Innenlagen der Leiterplatte nur noch quer zur Einführrichtung gestaucht, während im Gegensatz zu bekannten Pins Scherkräfte und eine dadurch hervorgerufene Dehnbeanspruchung in den Innenlagen verhindert und somit der Jeteffekt und die damit verbundene Gefahr eines Innenlagenabrisses vermieden werden kann. Außerdem kann durch das erfindungsgemäße Verfahren der Pin ohne Kraftaufwand und ohne die Gefahr einer Bildung von Späne oder Flittern in der Aufnahmeöffnung der Leiterplatte positioniert werden. Dies bedeutet wiederum, dass die weiche metallische Gleitschicht an der Oberfläche des Pin entbehrlich ist, die bei bekannten Pins die Reibung zwischen der Begrenzungswand der Aufnahmeöffnung und dem Kontaktteil beim Einpressen der Pins vermindert, so dass der Pin an Stelle der zumeist aus Zinn bestehenden Gleitschicht mit einer aus Nickel oder Nickel und Zinn bestehenden Oberflächenbeschichtung versehen werden kann, wodurch sich Einsparungen bei der galvanischen Beschichtung der Pins ergeben.

Im Rahmen der vorliegenden Anmeldung soll unter Kontaktteil der innerhalb der Aufnahmeöffnung der Leiterplatte befindliche Teil des Pin verstanden werden, der sich in elektrischen Kontakt mit den Leiterbahnen oder gedruckten Schaltungen der Leiterplatte bringen lässt.

Die Erfindung sieht vor, dass der Pin im Bereich des Kontaktteils zwei nebeneinander her verlaufende, durch einen Spalt oder Zwischenraum getrennte Schenkelteile umfasst, die dem Kontaktteil einerseits eine das Einführen in die Aufnahmeöffnung erleichternde schlanke Form verleihen, sich jedoch andererseits durch Aufbringen von entgegengesetzten Längskräften außerhalb der Aufnahmeöffnung unter Durchbiegung innerhalb der Aufnahmeöffnung quer zur Einführrichtung aufweiten und dadurch mit Presssitz in der Aufnahmeöffnung verankern lassen.

Um die Herstellung des aus zwei Schenkelteilen bestehenden Kontaktteils zu erleichtern, sind die Schenkelteile durch einen in Einführrichtung vorderen Endteil des Pin einstückig miteinander verbunden, der sich beim Einführen des Pin durch die Aufnahmeöffnung hindurch bewegt und über die entgegengesetzte Seite der Leiterplatte übersteht, sobald sich der Kontaktteil innerhalb der Aufnahmeöffnung befindet.

Einer der beiden Schenkelteile weist ein zum anderen Schenkelteil hin umgebogenes freies Ende mit einer von der Leiterplatte abgewandten Krafteinleitungsfläche auf, an der mittels eines Setzwerkzeugs eine zur Verformung der Schenkelteile dienende Deformationskraft in Einführrichtung in den mit der Krafteinleitungsfläche versehenen Schenkelteil und nach einer teilweisen Durchbiegung desselben auch in den anderen Schenkelteil eingeleitet werden kann. Während der Einleitung der Deformationskraft stützt sich der über die Leiterplatte überstehende Endteil des Pin auf einem Amboss oder Widerlager ab, von dem eine zur Deformationskraft entgegengesetzte Reaktionskraft in die beiden Schenkelteile eingeleitet wird, die infolgedessen zwischen dem Setzwerkzeug und dem Widerlager oder Amboss zusammengedrückt und daher innerhalb der Aufnahmeöffnung auseinander gebogen und aufgeweitet werden. Der Amboss oder das Widerlager bildet zweckmäßig auch einen Anschlag für den Endteil des Pin, um dessen Einführtiefe beim Einführen in die Aufnahmeöffnung auf ein gewünschtes Maß zu begrenzen, bei dem durch die Verformung des Kontaktteils eine optimale Kontaktierung möglich ist.

Die zur Positionierung des Pin in der Aufnahmeöffnung benötigte Kraft kann vom Setzwerkzeug zwar grundsätzlich ebenfalls in die Krafteinleitungsfläche des einen Schenkelteils des Kontaktteils eingeleitet werden, wird jedoch vorteilhaft auf eine weitere, von der Leiterplatte abgewandte Krafteinleitungsfläche ausgeübt, die zweckmäßig an einem seitlich überstehenden Vorsprung des Pin ausgebildet sein kann.

Zur Positionierung des Kontaktteils in der Aufnahmeöffnung wird dieser von einer Seite der Leiterplatte her berührungslos oder mit Gleitpassung in die Aufnahmeöffnung eingeführt, bis der Pin mit seinem vorderen Endteil gegen das Widerlager oder den Amboss anschlägt, wenn der Kontaktteil die optimale Position zur Kontaktierung der Leiterplatte erreicht. Anschließend wird der Kontaktteil durch die Verformung mit Presssitz in der Aufnahmeöffnung verankert, indem ein Teil des Kontaktteils in Einführrichtung zwischen dem Widerlager oder Amboss und einem Setzwerkzeug zusammengedrückt wird, das gegen eine von der Leiterplatte abgewandte Krafteinleitungsfläche des Kontaktteils angepresst wird.

Im Folgenden wird die Erfindung anhand eines in der Zeichnung dargestellten Ausführungsbeispiels näher erläutert. Es zeigen:
Fig. 1: eine perspektivische Ansicht eines Pin nach dem Einführen in eine Aufnahmeöffnung einer Leiterplatte;
Fig. 2: eine perspektivische Ansicht des Pin und der Aufnahmeöffnung nach einem Setzen des Pin und einem Kontaktieren der Leiterplatte.

Der in der Zeichnung dargestellte Pin 2 dient zum Herstellung einer lötfreien elektrischen Verbindung zwischen einer Leiterplatte 4 und einem nachträglich auf der Leiterplatte 4 zu montierenden elektrischen oder elektronischen Bauelement (nicht dargestellt), aus dem der Pin 2 ggf. zusammen mit weiteren Pins, zum Beispiel als Teil einer sogenannten Messerleiste (nicht dargestellt), übersteht.

Die in der Zeichnung dargestellte mehrschichtige Leiterplatte 4, zum Beispiel die Leiterplatte 4 eines Airbag-Steuergeräts eines Kraftfahrzeugs, weist insgesamt vier im Abstand angeordnete parallele Leiterebenen E1, E2, E3, E4 auf, in denen jeweils eine gedruckte Schaltung 6, 8, 10, 12 in Form von Leiterbahnen aus einer dünnen, mit Aussparungen versehenen Kupferlage angeordnet ist. Während die beiden gedruckten Schaltungen 6 und 12 auf den entgegengesetzten Breitseitenflächen der Leiterplatte 4 angeordnet sind und jeweils eine Außenlage bilden, sind die beiden gedruckten Schaltungen 8 und 10 im Inneren der Leiterplatte 4 angeordnet und bilden zwei Innenlagen, die durch isolierende Schichten 14, 16, 18 aus dem Prepreg-Material der Leiterplatte 4 voneinander und von den gedruckten Schaltungen 6, 12 der Außenlagen getrennt sind. Die gedruckten Schaltungen 6, 8, 10, 12 der vier Lagen sind mit Hilfe von Durchkontaktierungen (nicht dargestellt) untereinander bzw. mit Hilfe von Lötpins (nicht dargestellt) mit vormontierten elektronischen Bauelementen (nicht dargestellt) auf der Oberseite der Leiterplatte 4 verbunden.

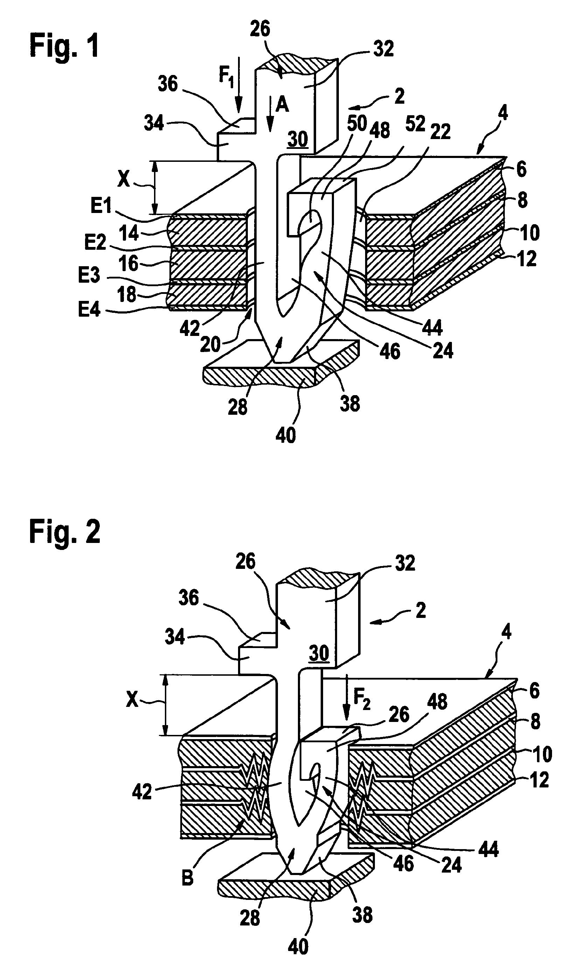

Zur Aufnahme des Pin 2 ist die Leiterplatte 4 an einer der Position des Pin 2 entsprechenden Stelle mit einer Standard-Leiterplattenbohrung 20 versehen, die sich durch die gesamte Leiterplatte 4 einschließlich der vier gedruckten Schaltungen 6, 8, 10, 12 bzw. Kupferlagen hindurch erstreckt, wobei diejenigen Lagen, mit denen der Pin 2 in Kontakt treten soll, im vorliegenden Fall alle vier Lagen, an der zylindrischen Begrenzungswand 22 der Leiterplattenbohrung 20 frei liegen, wie am besten in Fig. 1 dargestellt, während diejenigen Lagen, mit denen der Pin 2 nicht in Kontakt treten soll, mit einer die Leiterplattenbohrung 20 umgebenden Aussparung versehen sind.

Der durch Stanzen aus Metallblech hergestellte Pin 2 besteht im Wesentlichen aus einem von der Oberseite der Leiterplatte 4 her in Richtung des Pfeils A in Fig. 1 in die Leiterplattenbohrung 20 einführbaren und nach dem Einführen in die Bohrung 20 quer zur Einführrichtung mechanisch aufweitbaren Kontaktteil 24, einem den Kontaktteil 24 mit dem elektronischen Bauelement verbindenden Verbindungs- oder Schaftteil 26 (nur teilweise dargestellt), sowie einem freien Endteil 28, von denen nach dem Einführen des Kontaktteils 24 in die Leiterplattenbohrung 20 der erstere 26 über die Oberseite der Leiterplatte 4 bzw. die gedruckte Schaltung 6 und der letztere 28 über ihre Unterseite der Leiterplatte 4 bzw. die gedruckte Schaltung 12 übersteht. Der Verbindungs- oder Schaftteil 26, der Kontaktteil 24 und der Endteil 28 werden von zwei entgegengesetzten Seitenflächen 30 begrenzt, die entsprechend den Breitseitenflächen des zum Ausstanzen verwendeten Metallblechs in zwei zueinander parallelen Ebenen liegen.

Der Verbindungs- oder Schaftteil 26 weist am unteren Ende eines verdickten Oberteils 32 einen einseitig überstehenden Vorsprung 34 auf, dessen von der Leiterplatte 4 abgewandte Oberseite 36 abgeflacht und senkrecht zur Einführrichtung A ausgerichtet ist, so dass mit Hilfe eines Setzwerkzeugs (nicht dargestellt) einer Setzmaschine eine Einführkraft F₁ (Fig. 1) in Einführrichtung A auf den Vorsprung 34 und damit auf den Pin 2 ausgeübt werden kann, um den Kontaktteil 24 so weit in die Leiterplattenbohrung 20 einzuführen, bis der verjüngte Endteil 28 mit seinem freien Ende 38 gegen ein von einem Amboss 40 gebildetes Widerlager anschlägt und eine der Leiterplatte 4 zugewandte Unterseite des Vorsprungs 34 einen vorbestimmten Abstand x von der Oberseite der Leiterplatte 4 bzw. der gedruckten Schaltung 6 aufweist.

Der durch seine Aufweitung innerhalb der Leiterplattenbohrung 20 verankerbare Kontaktteil 24 besteht im Wesentlichen aus zwei etwa parallel zur Einführrichtung A ausgerichteten, durch einen Zwischenraum 46 getrennten Schenkelteilen 42, 44, deren untere Enden jeweils mit dem Endteil 28 und über diesen einstückig miteinander verbunden sind. Die beiden Schenkelteile 42, 44 weisen in unverformtem Zustand (Fig. 1) jeweils eine zur Einführrichtung A parallele Außenseite und eine dem Zwischenraum 46 zugewandte Innenseite auf.

Die Abstände der beiden Außenseiten bzw. die Abstände der beiden Seitenflächen 30 sind so an den Innendurchmesser der Leiterplattenbohrung 20 angepasst, dass nicht nur der verjüngte Endteil 28 sondern auch der Kontaktteil 24 entweder völlig berührungslos oder aber mit Gleitpassung, d.h. mit Gleitkontakt zwischen den Ecken der Schenkelteile 42, 44 und der Begrenzungswand 22, aber ohne eine Verformung der Schenkelteile 42, 44 oder der Begrenzungswand 22 in die Leiterplattenbohrung 20 einführbar ist, so dass zur Positionierung des Pin 2 eine relativ kleine Einführkraft F₁ von wenigen N ausreichend ist.

Während sich der Schenkelteil 42 vom verdickten Oberteil 32 des Verbindungs- oder Schaftteils 26 bzw. von der Unterseite des Vorsprungs 34 aus durch die Leiterplattenbohrung 20 hindurch geradlinig nach unten bis zum Endteil 28 erstreckt und eine zu seiner Außenseite parallele Innenseite besitzt, erstreckt sich der Schenkelteil 44 jenseits des Zwischenraums 46 vom Endteil 28 aus nach oben, wobei jedoch sein oberes Ende 48 hakenförmig nach innen zum Schenkelteil 42 hin umgebogen ist. Die Innenseite des Schenkelteils 44 divergiert vom Endteil 28 aus nach oben zu zuerst von der Innenseite des Schenkelteils 42 und erstreckt sich dann entlang eines Bogens 50 auf den Schenkelteil 42 zu, wobei sie insgesamt gesehen etwa die Form des oberen Teils eines Fragezeichens aufweist.

Das umgebogene obere Ende 48 des Schenkelteils 44 weist eine nach oben weisende abgeflachte Stirnfläche 52 auf, die senkrecht zur Einführrichtung A ausgerichtet ist und deren Abstand von der darüber angeordneten Unterseite des verdickten Oberteils 32 des Verbindungs- oder Schaftteils 26 ausreichend groß ist, um das zur Verankerung des Kontaktteils 24 dienende Setzwerkzeug (nicht dargestellt) zwischen diese beiden Flächen einzuführen und mit dem Setzwerkzeug eine in Einführrichtung A wirkende Deformationskraft F₂ (Fig. 2) auf die Stirnfläche 52 auszuüben, um durch die Verformung des Kontaktteils 24 den elektrischen Kontakt zwischen dem Pin 2 und den Lagen 6, 8, 10, 12 der Leiterplatte 4 herzustellen.

Die auf die Stirnfläche 52 ausgeübte Deformationskraft bewirkt, dass der Schenkelteil 44 in Längsrichtung zwischen dem Setzwerkzeug und dem Widerlager bzw. Amboss 40 zusammengedrückt oder zusammengequetscht wird, wie in Fig. 2 dargestellt, wobei sich zuerst das hakenförmig nach innen umgebogene obere Ende 48 des Schenkelteils 44 an die Innenseite des anderen Schenkelteils 42 annähert und dann gegen diese angepresst wird, bevor dann beide Schenkelteile 42, 44 unter Aufweitung des Kontaktteils 24 quer zur Einführrichtung A auseinander gebogen und jeweils gegen einen benachbarten Teil der Begrenzungswand 22 der Leiterplattenbohrung 20 angepresst werden. Dabei wird die Leiterplatte 2 mit den Innenlagen 8, 10 zuerst im Bereich der Ecken der Schenkelteile 42, 44 und dann auch gegenüber von den Außenseiten der Schenkelteile 42, 44 quer zur Einführrichtung A gestaucht, wie an der durch den Pfeil B in Fig. 2 angezeigten Stelle dargestellt, bis der Kontaktteil 24 schließlich mit Presssitz sicher in der Leiterplattenbohrung 20 verankert ist und der Pin 2 von der Leiteplatte 4 mit einer ausreichenden Haltekraft festgehalten wird.

Durch die beschriebene Vorgehensweise lässt sich der Jeteffekt in der Leiterplatte 4 vermeiden, wodurch die Qualität der Leiterplatte 4 beim Einsetzen des Pin 2 bewahrt und ihre Lebensdauer verlängert werden kann. Außerdem wird ein Abtrag von Späne oder Flittern von der Oberfläche des Pin 2 beim Positionieren oder Setzen desselben vermieden, wodurch eine Beschichtung der Oberfläche mit einer zum Beispiel aus Zinn bestehend weichen metallischen Gleitschicht vermieden werden kann. Da die Richtung der Einleitung der Kräfte F₁ und F₂ bei der Positionierung und bei der Kontaktierung des Pin 2 dieselbe ist, lassen sich zudem für beide Vorgänge kurze Taktzeiten erreichen.

## Patentansprüche

1. Verfahren zum Einsetzen eines Pin in eine Aufnahmeöffnung einer Leiterplatte, bei dem der Pin von einer Seite der Leiterplatte her in die Aufnahmeöffnung eingeführt und ein Kontaktteil des Pin mit Presssitz in der Aufnahmeöffnung verankert wird, wobei der Kontaktteil (24) berührungslos oder mit Gleitpassung in die Aufnahmeöffnung (20) eingeführt und anschließend innerhalb der Aufnahmeöffnung (20) verformt wird, um ihn mit Presssitz in der Aufnahmeöffnung (20) zu verankern, wobei der Kontaktteil (24) zwei nebeneinander her verlaufende Schenkelteile (42, 44) umfasst, die durch einen in Einführrichtung (A) vorderen Endteil (28) einstückig miteinander verbunden sind und wobei einer (44) der beiden Schenkelteile (42, 44) ein zum anderen Schenkelteil (42) hin umgebogenes freies Ende (48) aufweist,
**dadurch gekennzeichnet, dass** der Pin (2) bis zum Anschlagen gegen ein Widerlager (40) auf der entgegengesetzten Seite der Leiterplatte (4) in die Aufnahmeöffnung (20) eingeführt wird, wobei der Kontaktteil (24) verformt wird, indem mindestens ein Teil (44) des Kontaktteils (24) zwischen einem Setzwerkzeug und dem Widerlager (40) zusammengedrückt und dabei verbogen wird, indem das Setzwerkzeug gegen eine von der Leiterplatte (4) abgewandte Fläche (52) des Kontaktteils (24) angepresst wird, wobei die Fläche (52) gegen die das Setzwerkzeug angepresst wird, an dem freien Ende (48) angeordnet ist.

2. Verfahren nach Anspruch 1, **dadurch gekennzeichnet, dass** der Pin (2) eine weitere, von der Leiterplatte (4) abgewandte Krafteinleitungsfläche (36) aufweist, in die vom Setzwerkzeug eine zur Positionierung des Pin (2) in der Aufnahmeöffnung (20) benötigte Kraft eingeleitet wird.

## Claims

1. Method for inserting a pin into a receiving opening in a printed circuit board, in which the pin is introduced into the receiving opening from one side of the printed circuit board, and a contact portion of the pin is anchored in the receiving opening by force fit, wherein the contact portion (24) is introduced into the receiving opening (20) contactlessly or with a sliding fit and is then deformed inside the receiving opening (20) in order to anchor it in the receiving opening (20) by force fit, wherein the contact portion (24) comprises two limb portions (42, 44) running back next to one another which are integrally connected to one another by an end portion (28) which is at the front in the direction of introduction (A) and wherein one (44) of the two limb portions (42, 44) has a free end (48) which is bent around towards the other limb portion (42),
**characterized in that** the pin (2) is introduced into the receiving opening (20) until it hits an abutment (40) on the opposite side of the printed circuit board (4), wherein the contact portion (24) is deformed by virtue of at least one portion (44) of the contact portion (24) being pushed together between a setting tool and the abutment (40) and being bent in the process by virtue of the setting tool being pressed against an area (52) of the contact portion (24) which is remote from the printed circuit board (4), wherein the area (52) against which the setting tool is pressed is arranged at the free end (48).

2. Method according to Claim 1, **characterized in that** the pin (2) has a further force-introduction area (36), which is remote from the printed circuit board (4), into which a force required for positioning the pin (2) in the receiving opening (20) is introduced by the setting tool.

## Revendications

1. Procédé d'introduction d'une broche dans une ouverture de réception d'une carte de circuits imprimés, selon lequel la broche est insérée dans l'ouverture de réception depuis un côté de la carte de circuits imprimés et une partie de contact de la broche est ancrée dans l'ouverture de réception avec un ajustement serré, la partie de contact (24) étant insérée sans contact ou avec un ajustement glissant dans l'ouverture de réception (20) et étant ensuite déformée à l'intérieur de l'ouverture de réception (20) afin d'ancrer cette partie de contact dans l'ouverture de réception (20) avec un ajustement serré, la partie de contact (24) comportant deux parties formant branche (42, 44) s'étendant l'une à côté de l'autre, qui sont reliées l'une à l'autre d'un seul tenant par une partie d'extrémité (28) située à l'avant dans la direction d'insertion (A), et l'une (44) des deux parties formant branche (42, 44) comprenant une extrémité libre (48) repliée en direction de l'autre partie formant branche (42), **caractérisé en ce que** la broche (2) est insérée dans l'ouverture de réception (20) jusqu'à venir en butée contre une butée (40) située du côté opposé de la carte de circuits imprimés (4), la partie de contact (24) étant déformée du fait qu'au moins une partie (44) de la partie de contact (24) est comprimée entre un outil de pose et la butée (40) et est en l'occurrence recourbée, du fait que l'outil de pose est pressé contre une surface (52) de la partie de contact (24) qui est opposée à la carte de circuits imprimés (4), la surface (52) contre laquelle l'outil de pose est pressé étant disposée au niveau de l'extrémité libre (48).

2. Procédé selon la revendication 1, **caractérisé en ce que** la broche (2) comprend une surface d'application de force (36) supplémentaire opposée à la carte de circuits imprimés (4), dans laquelle surface d'application de force est appliquée, par l'outil de pose, une force nécessaire pour positionner la broche (2) dans l'ouverture de réception (20).
